# EUROPÄISCHE PATENTSCHRIFT

(11) **EP 0 668 609 B1**
(45) Veröffentlichungstag und Bekanntmachung des Hinweises auf die Patenterteilung: **09.06.2010**
(21) Anmeldenummer: 95102508.9
(22) Anmeldetag: 22.02.1995
(51) Int. Cl.: H01L 21/311, H01L 21/3213, H01L 21/3065, H01L 21/302, H01L 21/00

(54) **Verfahren zur plasmaunterstützten Rückseitenätzung einer Halbleiterscheibe bei belackungsfreier Scheibenvorderseite**
Process for plasma etching the backside of a semiconductor wafer, the front surface not being coated with a protective resin
Procédé d'attaque par plasma de la face arrière d'une plaquette semi-conductrice, la face avant étant libre de vernis protecteur

(30) Priorität: 22.02.1994 DE 4405667; 25.01.1995 DE 19502777
(43) Veröffentlichungstag der Anmeldung: 23.08.1995
(73) Patentinhaber: Infineon Technologies AG, 85579 Neubiberg (DE)
(72) Erfinder: Mathuni, Josef, Dr. Dipl.-Phys., D-81737 München (DE)
(74) Vertreter: Kindermann, Peter

(56) Entgegenhaltungen:
- EP-A- 0 414 038
- US-A- 4 857 142
- US-A- 5 280 894
- PATENT ABSTRACTS OF JAPAN vol. 018, no. 116 (E-1515), 24.Februar 1994 & JP 05 315300 A (TOSHIBA CORP), 26.November 1993,
- JOURNAL OF VACUUM SCIENCE AND TECHNOLOGY: PART A, Bd. 7, Nr. 3, 1.Mai 1989, Seiten 1719-1723, XP000226674 HEIDE P A M VAN DER ET AL: "ETCHING OF THIN SIO2 LAYERS USING WET HF GAS"
- PATENT ABSTRACTS OF JAPAN vol. 016, no. 004 (E-1151), 8.Januar 1992 & JP 03 228321 A (NEC CORP), 9.Oktober 1991,

## Beschreibung

Verfahren zur plasmaunterstützten Rückseitenätzung einer Halbleiterscheibe bei belackungsfreier Scheibenvorderseite.

Die Erfindung betrifft ein Verfahren zur Herstellung von hochintegrierten Schaltungen auf einem Halbleitersubstrat, bei dem eine Scheibe aus Halbleitermaterial bei mindestens einem Abscheideprozeß von beiden Seiten beschichtet wird und bei dem anschließend die Beschichtung auf der Scheibenrückseite durch eine bei belackungsfreier Scheibenvorderseite durchgeführte Ätzung wieder entfernt wird.

Im Laufe des Herstellungsprozesses von Halbleiter-Bausteinen werden die üblicherweise aus Silizium bestehenden Scheiben immer wieder Abscheideprozessen unterzogen, bei denen die Scheiben verfahrensbedingt und/oder anlagenbedingt von beiden Seiten beschichtet werden. Im wesentlichen sind dies Oxidationen (thermisches Oxid) sowie CVD (Chemical Vapor Deposition)-Prozesse (Poly-Si-dotiert und undotiert, Siliziumoxid, Siliziumnitrid). Da der Aufbau mehrerer verschiedener Schichten auf der Wafer-Rückseite unerwünscht ist und zu Beeinträchtigungen anderer Prozesse führen kann, werden im Laufe des gesamten Fertigungsprozesses Rückseiten-Ätzschritte durchgeführt. Dies geschieht üblicherweise dadurch, daß die Vorderseite ganzflächig belackt wird und anschließend die jeweilige Schicht auf der Wafer-Rückseite mittels eines Naß- oder Trockenätzverfahrens wieder entfernt wird. Als Plasmaätz-Equipment wird beispielsweise Tokuda CDE 7^{®}, CDE 8^{®} oder Gasonics IPC^{®} verwendet. Danach muß der Lack auf der Scheibenvorderseite wieder entschichtet werden. Die bei dieser bekannten Art der Rückseiten-Ätzung auftretenden Zusatzschritte Belacken und Entlacken der Scheibenvorderseite erfordern Durchlaufzeit, Anlagenkapazität (Belackungsspur, Lackentschichtungsbecken bzw. O₂-Plasmastripper Reinigung) sowie einen nicht unerheblichen Chemikalienverbrauch.

Inzwischen ist jedoch auch ein Ätzverfahren auf naßchemischer Basis bekannt geworden, das ohne Vorderseiten-Belackung auskommt. Hersteller des entsprechenden Equipments (RST-100^{®}) ist die Firma SEZ, Villach. Bei diesem Verfahren werden die zum großen Teil bereits mit Strukturen versehenen SiliziumScheiben mit dem Gesicht, also der Scheibenvorderseite, nach unten auf einem rotierenden Luftpolster schnell drehen gelassen, während.von oben auf die Scheibenrückseite die naßchemische Ätzlösung fließt. Durch die schnelle Drehung der Scheibe wird bewirkt, daß die Chemikalien über den Rand der Scheibenrückseite hinweg nach außen geschleudert werden und so nicht die Vorderseite angreifen können.

Dieses bekannte Verfahren ist jedoch mit erheblichen Problemen verbunden, da zum einen das Erfordernis, eine teilprozessierte Silizium-Scheibe mit dem Gesicht nach unten und sicher vor Berührung und damit verbundener Beschädigung auf einem Luftpolster rotieren zu lassen, eine komplizierte und damit störanfällige Mechanik voraussetzt. Zum anderen wird in der Halbleiterherstellung das Beblasen der offenen Scheibenvorderseite normalerweise möglichst vermieden, um eine Partikelbelastung durch Aufwirbelungsvorgänge zu verhindern. Darüberhinaus ist der Chemikalienverbrauch bei diesem bekannten Verfahren naturgemäß sehr hoch, da wegen des Schleudervorgangs auf der Scheibenrückseite ein ständiges Nachfließen notwendig ist. Ein hoher Chemikalienverbrauch sollte aber schon aus Umweltschutzgründen vermieden werden.

Aus der Japanischen Offenlegungsschrift JP 531 53 00 ist eine Trockenätzkammer bekannt, die zum Trockenätzen eines Glassubstrates für ein TFT-Feld (Thin Film Transistor) mit neutralem, nicht angeregtem Gas dient.

Aus der US 4857142 sind ein Verfahren und eine ätzkammer zum Entfernen von Ablagerungen auf der Rückseite und am Rand eines Halbleiterwafers bekannt, wobei das Abtragen von Material auf der Vorderseite des Wafers durch ein schützendes Gas verhindert wird, siehe Oberbegriff des Patentanspruchs 1.

Der vorliegenden Erfindung liegt die Aufgabe zugrunde, ein gegenüber den genannten Nachteilen verbessertes Verfahren der eingangs genannten Art anzugeben, das also eine Scheiben-Rückseitenätzung ohne Vorderseiten Be- und Entlackung ermöglicht.

Diese Aufgabe wird bei einem Verfahren der eingangs genannten Art dadurch gelöst, daß die Ätzung in einer Prozeßkammer derart erfolgt, daß die in einem Plasma erzeugten reaktiven Teilchen nur die Scheibenrückseite erreichen, während deren Vordringen zur Scheibenvorderseite durch ein schützendes Neutralglas verhindert wird.

Weiterbildungen der Erfindung sind Gegenstand von Unteransprüchen.

Im folgenden wird die Erfindung anhand eines Ausführungsbeispiels und der Figuren der Zeichnung, die, schematisch und geschnitten, verschiedene Abdichtungsausführungen einer zur Durchführung des erfindungsgemäßen Verfahrens geeigneten Einzelscheiben-Ätzanlage zeigen, näher erläutert.

Erfindungsgemäß können die zu entfernenden Schichten auf der Scheibenrückseite insbesondere mit einem Mikrowellen- oder HF-angeregten Chemical Downstream Verfahren unter Verwendung von Fluor-Verbindungen geätzt werden, ohne daß der eigentliche Rückätzprozeß modifiziert werden müßte. Der Schutz der Scheibenvorderseite geschieht jedoch nicht mehr wie bisher durch Belacken und nachträgliches Entlacken, sondern über ein Neutralgas. Die Schutzwirkung des Neutralgases kann über ein geeignetes Design der Prozeßkammer und eine geeignete Prozeßführung unterstützt werden. Vorteilhaft beim erfindungsgemäßen Verfahren ist vor allem auch die Möglichkeit, die Silizium-Scheibe in ihrer natürlichen Lage, also mit dem Gesicht nach oben, nach bei Einzelscheiben-Ätzern üblichen Methoden vollautomatisch in die Prozeßkammer transportieren zu können.

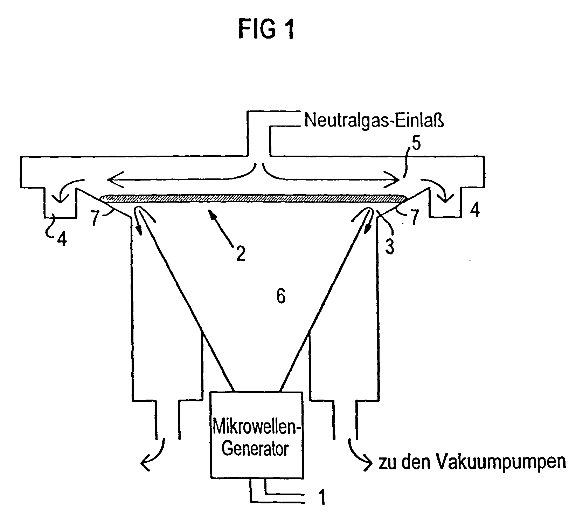

In der Figur 1 sind Teile eines Einzelscheiben-Ätzers schematisch dargestellt, bei dem die durch Mikrowellen angeregten reaktiven Teilchen des eingelassenen Ätzgases 1 während des Rückseitenätzens von unten her an die Scheibenrückseite 2 gelangen. Sie können anschließend zusammen mit den Ätzprodukten beispielsweise über einen ringförmigen Spalt 3, der unter dem Scheibenrand angeordnet ist, abgesaugt werden. Während des Ätzvorganges wird die Scheibenoberseite durch ein nicht ätzendes Neutralgas geschützt. Es kann beispielsweise Stickstoff, aber auch das nicht angeregte Ätzgas selbst, beispielsweise CF₄ oder NF₃, verwendet werden. Das Neutralgas kann beispielsweise, wie in der Figur 1 dargestellt, über der Scheibenmitte eingelassen und über den Scheibenrand hinweg über eine Ringleitung 4 abgesaugt werden. Für die Schutzwirkung des Neutralgases ist eine Gasströmung jedoch nicht unbedingt erforderlich.

Es ist vorteilhaft, wenn der Druck im oberen Prozeßkammerteil 5 mindestens gleich hoch wie im unteren Prozeßkammerteil 6 gewählt wird. Einerseits wird dadurch ein unbeabsichtigtes Anheben der Scheibe verhindert, während gleichzeitig der Überdruck über der Scheibe bewirkt, daß im Falle von Undichtigkeiten im Auflagebereich 7 des Scheibenrandes eine Gasströmung immer von oben nach unten stattfindet. Dadurch wird ein Eindringen von angeregten Ätzteilchen in den oberen Prozeßkammerteil 5 und damit ein Anätzen der Scheibenoberfläche verhindert. Das damit möglicherweise gegebene Eindringen von Neutralgas in den unteren Prozeßkammerteil 6 führt dagegen nur zu einer leichten Verdünnung des Ätzgases, was sich lediglich in einer geringfügigen Erhöhung der Inhomogenitäten der Ätzraten bemerkbar macht. Außerdem ist durch die Anbringung des Absaugspaltes 3 am Scheibenrand ein schnelles Wegpumpen des eingedrungenen Neutralgases gewährleistet. Allerdings sollte durch eine geeignete Profilanpassung der Auflagefläche im Flat-Bereich der Scheibe, oder durch Abdichten auf Stoß, die Ausbildung von Undichtigkeiten möglichst unterdrückt werden. Durch die in der Figur 1 dargestellte Abschrägung des Auflagebereichs 7 wird erreicht, daß die Ätzung bis zum Scheibenrand stattfinden kann. Bei entsprechend gewählter Form bzw. Abschrägung des Auflagebereichs 7 ist auch ein gezieltes Ätzen in die Kante der Scheibe hinein möglich. Die Abdichtung der beiden Prozeßkammerteile ist jedoch auch von oben her, beispielsweise durch einen am Außenrand der Scheibenvorderseite angreifenden Zylinder, möglich. Insgesamt liegt es durchaus im Rahmen der Erfindung, wenn auch der Außenrand der Scheibenvorderseite im wünschenswerten Umfang, höchstens wenige Millimeter, rückgeätzt wird. Im einzelnen wird in den folgenden Beispielen, die nicht Teil der Erfindung sind, wie folgt vorgegangen :

Die Scheibe wird in ihrer natürlichen Lage (Rückseite nach unten) beispielsweise mit mehreren Spitzen gegen eine Ringblende 8, gedrückt, die in ihrem Verlauf der Form des Wafers nachgebildet ist (Flat), wobei ein leichter Überdruck des Neutralgases auf der Innenseite der Blende verhindert, daß durch kleine Undichtigkeiten hindurch ein Angriff des Ätzgases auf die Scheibenoberseite stattfindet. Durch die Form und Größe der Ringblende wird schließlich auch der Bereich auf der Scheibe festgelegt, der vom Rand her zusätzlich freigeätzt werden soll.

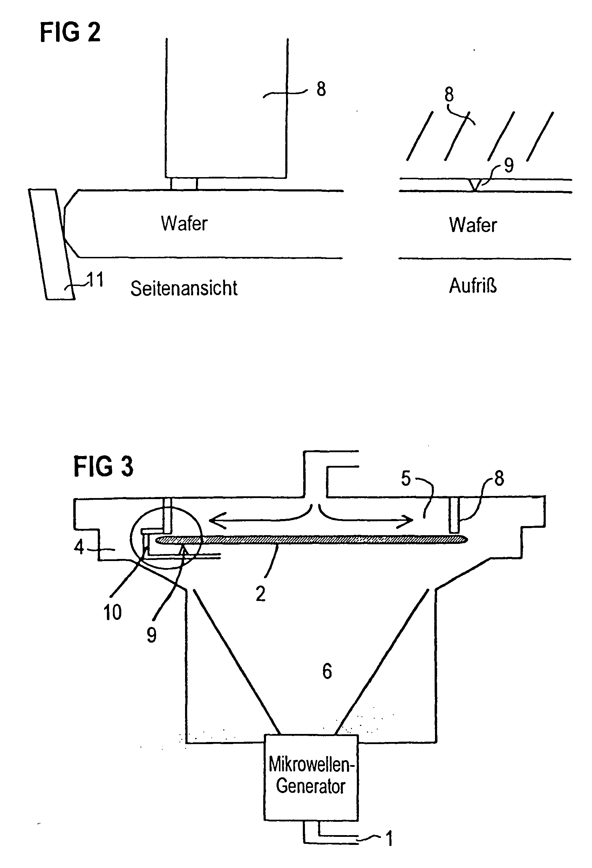

Zwar ist ein Berühren der Scheibenvorderseite im (nichtaktiven) Randbereich der Scheiben ein durchaus gängiges Verfahren (z.B. Clampringe für die He-Rückseitenkühlung bei RIE-Verfahren), dennoch wäre aus Defektdichtegründen eine möglichst geringe Auflagefläche bzw. ein berührungsloses Verfahren vorzuziehen. Zwei Möglichkeiten hierzu sind in Fig 2 bzw. Fig. 3 dargestellt.

Nach Fig. 2 wird die Scheibe durch mehrere keilförmige Abstandsnasen 9 über einen definierten Spalt (ca. 0,1 mm) von der Blende ferngehalten. Durch einen leichten Überdruck innerhalb der Blende 8 findet auch hier eine Gasströmung nach außen statt, die ein Eindringen von reaktiven Teilchen in den Raum über der Scheibe verhindert.

In Fig. 3 wird gezeigt, wie dieser Spalt über einen indirekten Anschlag 10 völlig berührungsfrei für die Vorderseite eingestellt werden kann.

Erfahrungsgemäß werden an den Stellen der Auflagepunkte der Haltespitzen 9 die Schichten während des isotropen Ätzvorganges mitentfernt. Dennoch kann bei Bedarf die Scheibe, wie in Fig. 2 gezeigt, durch runde Stifte 11 an Punkten im Scheibenrand selbst gehalten werden, so daß in Kombination mit einem indirekten Anschlag am Scheibenrand die Scheibe während der Ätzung weder auf der Oberseite noch auf der Unterseite berührt wird.

Als typische Parameter bei der Rückätzung einer 200 nm dicken Polysiliziumschicht auf thermischem Oxid seien genannt:

| | | |
|---|---|---|
| Scheibenoberseite: | N₂-Fluß | 5000 sccm |
| | Druck | 1, 8 torr (1 Torr = 133,3 Pa) |
| | | |
| Scheibenrückseite | CF₄-Fluß | 100 sccm |
| | O₂-Fluß | 50 sccm |
| | Druck | 1,5 torr |
| | | |
| Mikrowellenleistung | | 800 W |
| | | |
| Ätzzeit | | 1 min |

## Patentansprüche

1. Verfahren zur Herstellung von hochintegrierten Schaltungen auf einem Halbleitersubstrat,
bei dem eine Scheibe aus Halbleitermaterial bei mindestens einem Abscheideprozeß von beiden Seiten beschichtet wird, bei dem anschließend die Beschichtung auf der Scheibenrückseite durch eine bei belackungsfreier Scheibenvorderseite durchgeführte Ätzung wieder entfernt wird,
bei dem die Ätzung in einer Prozeßkammer derart erfolgt, daß die reaktiven Teilchen nur die Scheibenrückseite (2) erreichen, während deren Vordringen zur Scheibenvorderseite durch ein schützendes Neutralgas verhindert wird,
und bei dem Mittel zur mindestens teilweisen Abdichtung eines ersten, die Scheibenrückseite (2) enthaltenden Prozeßkammerteils (6) gegenüber einem zweiten, die Scheibenvorderseite enthaltenden Prozeßkammerteil (5) vorgesehen werden,
**dadurch gekennzeichnet,**
**daß** die mindestens teilweisen Abdichtung durch eine Profilanpassung der zur Prozeßkammer gehörenden Auflagefläche (7) des Scheibenrandes an den Flat-Bereich der Scheibe erfolgt, und
**daß** die reaktiven Teilchen in einem Plasma erzeugt werden.

2. Verfahren nach Anspruch 1,
**dadurch gekennzeichnet,**
**daß** der Druck des auf die Scheibenvorderseite wirkenden Neutralgases mindestens gleich hoch wie der auf die Scheibenrückseite (2) wirkende Druck gewählt wird.

3. Verfahren nach der Anspruch 1 oder 2,
**dadurch gekennzeichnet,**
**daß** die Scheibenvorderseite durch ein darüber strömendes Neutralgas geschützt wird.

4. Verfahren nach einem der Ansprüche 1 bis 3,
**dadurch gekennzeichnet,**
**daß** als Neutralgas das auch für die Ätzung eingesetzte, jedoch nicht angeregte Ätzgas verwendet wird.

5. Verfahren nach einem der Ansprüche 1 bis 3,
**dadurch gekennzeichnet,**
**daß** als Neutralgas Stickstoff verwendet wird.

6. Verfahren nach einem der Ansprüche 1 bis 5,
**dadurch gekennzeichnet,**
**daß** die Ätzung in einem Einzelscheiben-Ätzer mit horizontal nach oben weisender Scheibenvorderseite durchgeführt wird.

## Claims

1. Method for producing large scale integrated circuits on a semiconductor substrate,
in which a wafer composed of semiconductor material is coated during at least one deposition process from both sides,
in which the coating on the rear side of the wafer is subsequently removed again by means of an etching process carried out with the front side of the wafer not being provided with resist,
in which the etching process is effected in a process chamber in such a way that the reactive particles only reach the rear side (2) of the wafer, while they are prevented from penetrating as far as the front side of the wafer by means of a protective neutral gas,
and in which means for at least partly sealing a first process chamber part (6) which contains the rear side (2) of the wafer, from a second process chamber part (5) which contains the front side of the wafer, are provided,
**characterized**
**in that** the at least partial sealing is effected by a profile adaptation of the bearing surface (7) - associated with the process chamber - of the wafer edge to the flat region of the wafer, and
**in that** the reactive particles are produced in a plasma.

2. Method according to Claim 1,
**characterized**
**in that** the pressure of the neutral gas acting on the front side of the wafer is chosen to be at least equal in magnitude to the pressure acting on the rear side (2) of the wafer.

3. Method according to Claim 1 or 2,
**characterized**
**in that** the front side of the wafer is protected by a neutral gas flowing out.

4. Method according to any of Claims 1 to 3,
**characterized**
**in that** the neutral gas used is the etching gas also used for the etching process, said etching gas not being excited, however.

5. Method according to any of Claims 1 to 3,
**characterized**
**in that** the neutral gas used is nitrogen.

6. Method according to any of Claims 1 to 5,
**characterized**
**in that** the etching process is carried out in a single-wafer etcher with the front side of the wafer facing horizontally upwards.

## Revendications

1. Procédé de production de circuits très intégrés sur un substrat semiconducteur,
dans lequel on revêt sur les deux faces une tranche en matériau semiconducteur dans au moins une opération de dépôt,
dans lequel on élimine à nouveau ensuite le revêtement sur la face arrière de la tranche par une attaque effectuée alors que la face avant de la tranche est sans vernis,
dans lequel on effectue l'attaque dans une chambre de traitement de manière à ce que les particules réactives n'atteignent que la face (2) arrière de la tranche, tandis que leur avance vers la face avant de la tranche est empêchée par un gaz neutre de protection, et
dans lequel on prévoit des moyens pour rendre étanche au moins en partie une première partie (6) de la chambre de traitement contenant la face (2) arrière de la tranche vis-à-vis d'une deuxième partie (5) de la chambre de traitement contenant la face avant de la tranche,
**caractérisé en ce que** l'étanchéité au moins en partie est produite par une adaptation de profil de la surface (7) de support, appartenant à la chambre de traitement, du bord de la tranche à la partie plate de la tranche, et
**en ce que** l'on produit les particules réactives dans un plasma.

2. Procédé suivant la revendication 1,
**caractérisé en ce que** l'on choisit la pression du gaz neutre agissant sur la face avant de la tranche au moins aussi haut que la pression agissant sur la face (2) arrière de la tranche.

3. Procédé suivant la revendication 1 ou 2,
**caractérisé en ce que** l'on protège la face avant de la tranche par un gaz neutre s'écoulant dessus.

4. Procédé suivant l'une des revendications 1 à 3,
**caractérisé en ce que** l'on utilise comme gaz neutre le gaz d'attaque utilisé pour l'attaque, mais cependant non excité.

5. Procédé suivant l'une des revendications 1 à 3,
**caractérisé en ce que** l'on utilise de l'azote comme gaz neutre.

6. Procédé suivant l'une des revendications 1 à 5,
**caractérisé en ce que** l'on effectue l'attaque dans un dispositif d'attaque de tranches individuelles, alors que la face avant de la tranche est tournée horizontalement vers le haut.
